# EUROPEAN PATENT APPLICATION

(11) **EP 1 847 759 A2**
(43) Date of publication of application: **24.10.2007**
(21) Application number: 07106491.9
(22) Date of filing: 19.04.2007
(51) Int. Cl.: F21K 7/00

(54) **Multi chip LED lamp**

(30) Priority: 21.04.2006 US 408715
(71) Applicant: Wang, Xiaoping, Denver, CO 80216 (US)
(72) Inventor: Wang, Xiaoping, Denver, CO 80216 (US)
(74) Representative: Hellmich, Wolfgang

(57) **Abstract**

A multi chip LED lamp comprises a reflector and a plurality of LED chips mounted on a top surface of the reflector. A triple laminate board has a board layer; a circuit layer formed on the board layer; and a thermal conductor layer laminated under the board layer. A well is formed in the triple laminate board, the well sized to receive the reflector in snug fit. The multi chip LED circuit layer can be copper and the thermal conductor layer can be aluminum. A heat sink having fins can be attached to the thermal conductor layer. Material can be removed from the triple laminate board to form the well and reflector. Three or more LED chips can be mounted on the top surface of the reflector. The chips can be less than 2mm from each other.

## Description

Light emitting diodes or LED technology is almost to the point that it can provide environmental residential or office lighting. LEDs can generate bright light with low power consumption making LED DC lighting particularly suitable for DC power systems such as those installed in photovoltaic powered homes. This has a potential of saving a substantial amount of natural resources. Unfortunately, there are a few hurdles to overcome before LED lamps can replace compact fluorescent lamps.

According to related art, light emitting diodes do not convert all electricity into light and therefore generate a substantial amount of heat. United States Patent No. 7,008,084 issued to inventor Galli uses an integrated heat sink to dissipate heat from a high brightness LED into a lighting device. "In particular, the head assembly utilizes a receiver sleeve that includes a tail portion which surrounds the output end of the LED thereby isolating the LED and capturing both the conductive and radiant waste heat emitted by the LED to further dissipate the captured heat out of the assembly."

Other recent patents such as United States Patent 6,966,677 provides a Lighting assembly with sufficient space around the LED element to provide airflow and thermal dissipation. United States Patent No. 6,914,261 issued to inventor Ho provides an array of light emitting modules mounted on a substrate. The individual elements are arranged in an array so that they form a panel. Making elements larger, or arranging them as a panel increases cost and creates physical size limits.

United States Patent No. 6,561,680 provides an alternative configuration that increases the anode and cathode portions to have a larger surface area for heat dissipation. The resulting device is a large LED. Sometimes a number of smaller lamps substitute a large lamp. United States Patent 6,864,513 provides a light emitting diode bulb having multiple LEDs mounted on a circuit layer so that each chip 21 has wires 22 mounted within an encapsulant 23. Making a larger lamp, or connecting a large number of individual lamps also increases cost.

The previous patents and related art do not show a low-cost solution to allow a high-intensity LED light that also dissipates heat. Therefore, the object of the invention is to provide a new LED device structure with normal LED chips but a better heating dissipation function to allow a high-intensity LED light. Making large elements, or large heat exchangers are environmentally unfriendly. It is a further object of the invention to make the LED lamp environmentally friendly.
Fig. 1 is a perspective view of the device.
Fig. 2 is a cross section of the first embodiment.
Fig. 3 is a cross section of the lamp module of the second embodiment.
Fig. 4 is a cross section of the third embodiment.
Fig. 5 is a top view.

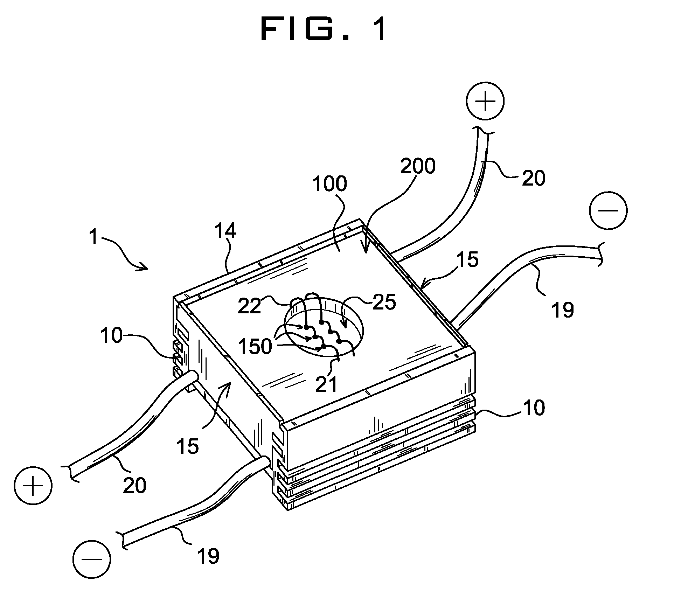

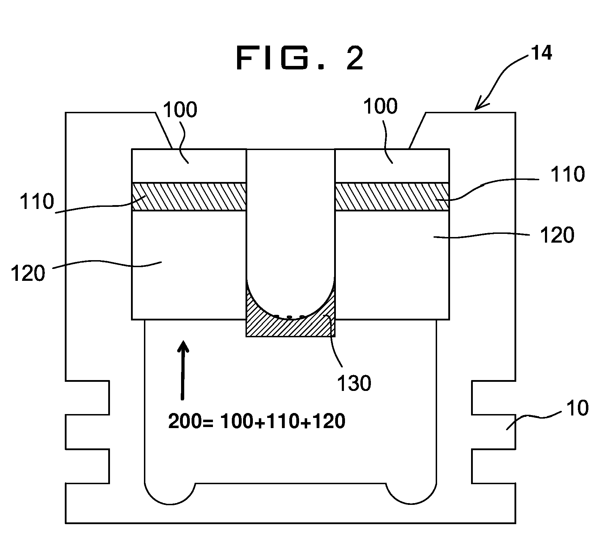

The device 1 shown in Fig. 1 is about one square inch. A preferred embodiment as shown in Fig. 1 has a pair of power wires 19 and 20 entering the housing 14 through heat dissipation area (300) and exiting the housing 14. The housing 14 can be modularly clipped or joined to the power wire 20 using wire piercing means that are commonly and commercially available. Modular joining allows connection along any section of power wire 20. The heat exchangers 10 can be integrally formed to the housing 14. The housing 14 is preferably extruded or rolled from aluminum, although a variety of metals can be used. The housing 14 has a housing cap 15 bounding each side of the housing 14 to form a rectangular or square shape. The heat exchangers 10 are shown as fins and can be arranged in a variety of shapes, configurations and sizes according to the state of the art in heat exchanger technology. The housing cap 15 also dissipates heat. The top cover 200 also called triple laminate layer of the device 1 consists of a triple layer: an electrically conductive layer 100 also called circuit layer 100, a structural layer (110) and a Heat conductive layer (120). The electrically conductive layer 100 can be made out of copper circuits printed on a printed circuit board. The term printed circuit board is sometimes abbreviated as PCB. The PCB fits within the housing and can slide into a front and rear slot formed within the housing as seen in Fig. 2. The top cover 200 may further have a non-conductive protective layer covering it. The layers of the device have a hole or well 25 formed where LED chip elements 150 are mounted on the upper surface of the reflector 130. The reflector is preferably parabolic, concave and bowl shaped.

Contrary to popular thinking, the LED chips 150 should be small and mounted closely together in multiples around the middle inside surface of the parabolic reflector 130. The chips 150 are created by ordinary chip fabrication means commonly known in the industry. Each chip 150 has an anode and cathode, but miniaturized to a degree that they are not noticeable by a casual observer. The chips will appear as small dots to a casual observer.

As is well known in the art, the reflector 130 can be coated with phosphorous or other light emitting chemical to enhance lumen output efficiency. Packing the chips 150 close together minimizes material usage and heat can be mitigated through dissipation. Preferably the chips are less than 2mm from each other. Although the chips can be about 5mm from each other, this is not the best configuration to form a spotlight.

A preferred embodiment as shown in Fig. 2 has an electrically conductive layer 100 over a circuit board structural layer 110 over a thermal conductive layer 120. The heat sink, or heat dissipation fin 10 is shown attached to the thermal conductive layer 120. The thermal conductive layer is either integrally formed with the reflector 130 as shown in Fig. 2 or is inserted into the well 25 after a through hole is drilled through the triple layer. Normally, the connecting wires 21 that provide electricity to the chip elements 150 are small and not usually noticeable. The lead wires 21 lead from the conductive layer 100 to the chip elements 150, and bridge between the chip elements to lead back to the conductive layer 100.

The reflector shown in Fig. 2 of the first embodiment can be produced separately but integrally formed with the triple laminate layers (200) or formed directly by drilling a depression on the triple laminate layer (200) and this depression does not pass through the entire triple laminate layer so that it can act as reflector.

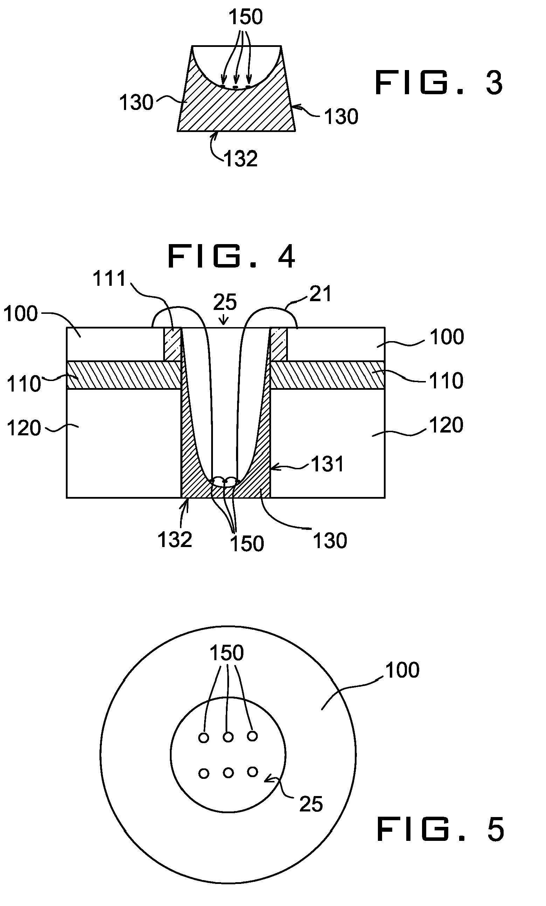

A second embodiment as shown in Fig. 3 is also a preferred embodiment and has a reflector insert 130 with a flat bottom 132 and angled sides. The insert can be manufactured separately and sized to the hole 25 size. The chip elements 150 can also be mounted on the reflector insert 130. When the reflector insert is inserted into the triple laminate layer as shown in Fig. 2, the reflector sidewalls 131 automatically interference fit to the thermal conductive layer 120.

As shown in Fig. 4, the third embodiment provides a parabolic reflector having walls that reach to the top surface of the conductive layer. The conductive layer 100 is isolated from the reflector by an annular groove or insulation 111. The structural layer 110 is not conductive and serves only to provide structure. The top view shows a conductive layer 100 encircling six chips. A protective layer can cover the chips. The chips are mounted close to each other in a densely packed array of three, four, five, six...N pcs or nine chips. The anode and cathode sizes remain small providing manufacturing economy. Connection wiring 21, 22 may be connected in redundant connections providing a back up connection in case the main connection fails. The chips generate heat. The heat conducts through the thermal conductive reflector 130 that has integral or tight connection on a sidewall 131 that interfaces the thermal conductive layer 120. The thermal conductive layer 120 will transfer the heat to the extruded housing (14) via the joint sidewall 131 and heat dissipation 300 or heat convective area 300. Thus a better heat dissipation structure is ensured. The thermal conductive layer 120 can be made out of aluminum. Heat dissipation area 300 can be hollow and also act as a channel for power wiring 19, 20.

Fig. 2 shows a thin reflector embodiment having small clearance between the bottom of the reflector and the concave area of the reflector. Fig. 3 shows a thick reflector embodiment that provides mechanical strength for insertion into the through hole to form the well 25. The thin reflector embodiment is not preferred when using a manufacturing method that requires inserting the reflector into the through hole. The thin reflector embodiment should be used when the reflector 130 is integrally formed, or drilled from the triple laminate layer.

For a focused beam commonly seen in a flashlight, the walls and sides 131 of the reflector can be higher than the width of the base 132. The top of the walls 131 may be isolated from the conductive layer 100 by a small gap. The large gap shown in the drawings is mainly for illustration purposes. The conductive layer 100 is typically formed as a copper conductive circuit that is printed on an isolation board that may be made in a variety of circuit configurations.

During manufacturing, the triple laminate printed circuit board is made by laminating a thermal conductive layer 120 on a board 110 and printing a conductive layer 100 on top. The circuit can be as simple as having the front potion of connecting wire 21 correspond with power wire 19, and the back potion of connection wire 22 with power wire 20, with a central conductive layer strip portion between 19 and 20 missing or not conductive. In this case, the connecting wire 22 bridges a positive back portion, to the chips 150, the connecting wire 21 to the negative front portion. If the front power wire and back power wire are of different polarity, the wiring can receive a number of devices 1 in parallel configuration. Fig. 1 shows two rows of three chips 150 in parallel. If each chip of Fig. 1 is 4V, the total voltage would be 12V. If the LED chips are sized and matched to voltage, resistors are not necessary. Any voltage is possible. Typical lighting voltages are 3V, 6V, 12V,... 120V, 240V, etc. The LED chips are small and/or PCB based.

After circuit printing, the triple laminate printed circuit board can either be drilled through or drilled partially through as seen in Fig. 2. When the board is drilled through, the reflector insert 130 is inserted from the bottom opening of the thermal conductive layer 120. The insertion of the reflector 130 may require a tool such as a crimp tool. After reflector insertion, a wiring machine installs the connecting wire 21 for the chips 150.

The well 25 is preferably round and empty without the waterproof resin typically associated with LED lamps. Of course, a waterproof lid or some kind of protective layer can be added if necessary. Either the chips 150 or the protective lens layer can be colored, or multicolored providing a variety of color outputs.

The chips 150 can be in rectangular array arrangement, but can also be formed in a circular pattern. As seen in the drawings, the reflector 130 can be of any shape, and can also be square, or rectangular. The reflector can be linearly formed as a long trough where the chips are laid in linear configuration. The linear configuration can be arranged in a single row of led chips 150, or a double row of led chips 150. The linear configuration can be formed as a ring or loop if long enough. The best mode currently is to have the reflector in a parabolic configuration having a circular top light opening formed as a well 25.

### CALL OUT LIST OF ELEMENTS

- 1: LED device
- 10: Heat Exchanger
- 14: Extruded Housing
- 15: Housing Cap
- 19: Negative Power wires
- 20: Positive Power Wires
- 21: Front Connecting Wires
- 22: Back Connecting wires
- 25: Reflector Well
- 100: Electrical Conductive Layer
- 110: Structural Layer
- 111: Insulation Layer or Gap
- 120: Heat Conductive Layer
- 130: Reflector
- 131: Reflector Side Wall
- 132: Reflector Bottom
- 150: LED
- 200: Top cover triple laminate layer
- 300: Heat convective area

## Claims

1. A multi chip LED lamp comprising:
a. a reflector;
b. a plurality of LED chips mounted on a top surface of the one reflector;
c. a triple laminate board comprising: a board layer; a circuit layer formed on the board layer; and a thermal conductor layer laminated under the board layer.
d. a well formed in the triple laminate board, the well sized to receive the reflector in snug fit.

2. The multi chip LED lamp of claim 1, wherein the circuit layer is copper and the thermal conductor layer is aluminum.

3. The multi chip LED lamp of one of claims 1 or 2, further comprising a heat sink having fins attached to the thermal conductor layer.

4. The multi chip LED lamp of one of claims 1 to 3, wherein a step of removing material from the triple laminate board forms the well and reflector.

5. The multi chip LED lamp of one of claims 1 to 4, wherein three or more LED chips are mounted on the top surface of the reflector.

6. The multi chip LED lamp of claim 5, wherein the chips are less than 2mm from each other.

7. The multi chip LED lamp of claim 6, wherein the reflector has a base width and height, wherein the width is greater than the height.

8. The multi chip LED lamp of claim 6, wherein the reflector has a base width and height, wherein the height is greater than the width.

9. The multi chip LED lamp of one of claims 1 to 8, wherein a first step of forming a through hole to form the well in the triple laminate board and a second step of inserting a reflector into the well forms the well and reflector.

10. A multi chip LED lamp construction process comprising the steps of:
a. forming a reflector;
b. mounting more than three LED chips on a top surface of the reflector;
c. forming a triple laminate board comprising: a board layer; a circuit layer formed on the board layer; and a thermal conductor layer laminated under the board layer;
d. forming a through hole to form a well in the triple laminate board;
e. inserting the reflector into the well wherein the reflector is in snug fit with the through hole or the triple laminate board; and
f. connecting the PCB to the chips with connecting wire.
